# EUROPEAN PATENT APPLICATION

(11) **EP 4 679 171 A1**
(43) Date of publication of application: **14.01.2026**
(21) Application number: 24188306.5
(22) Date of filing: 12.07.2024
(51) Int. Cl.: G03F 7/00, B29C 33/38, B29D 11/00

(54) **METHOD FOR FABRICATION OF VARIABLE DEPTH PRINT MASTER FOR NANOIMPRINT LITHOGRAPHY**

(71) Applicant: Imec VZW, 3001 Leuven (BE)
(72) Inventor: TRAUB, Matthew, 1933 Sterrebeek (BE); DE BACKKER, Kris, 3071 Erps-Kwerps (BE); GÜELL I GRAU, Pau, 3000 Leuven (BE); STORACE, Eleonora, 3000 Leuven (BE); HUMBERT, Aurelie, 1030 Schaarbeek (BE)
(74) Representative: Winger

(57) **Abstract**

A method for producing a master template with variable height features for imprint lithography on a device substrate includes providing a layer stack comprising a substrate, an etch stop layer on the substrate, and a pattern layer on the etch stop layer. The method involves creating height gradation in the pattern layer to obtain a height graded pattern layer, forming the master template by providing a pattern comprising a plurality of features into the height graded pattern layer. This method enables the production of features with varying heights, which can be particularly useful in applications such as optical devices where such features may influence the functionality and efficiency of the device.

## Description

### Field of the invention

The present invention relates to the field of nanoimprint lithography, specifically to the fabrication of masters for imprinting variable depth features on substrates.

### Background of the invention

Nanoimprint lithography has emerged as a pivotal technology in the field of microfabrication, particularly for the production of low-cost, high-resolution patterns. This method involves the physical contact of a surface-relief patterned surface with an imprint resist and subsequent curing or hardening processes to create surface-relief structures on a substrate. It is especially significant for the fabrication of waveguide combiners for augmented reality displays.

A major challenge in the current landscape of nanoimprint lithography is the single-step replication of features with varying depths on a single substrate. By varying the height of surface relief gratings, the outcoupling efficiency of light can be controllably varied over a large area, enabling significant improvements in both the colour uniformity and the brightness uniformity of the waveguide combiner display. Traditional methods often require multiple and complex photolithography steps, each tailored to achieve different feature depths, which can be both time-consuming and expensive. Moreover, the substrates used in such applications may not always be compatible with conventional CMOS processing tools, which further complicates the manufacturing process.

Despite the advancements in nanoimprint lithography, there remains a significant need for further innovation in this field to overcome the challenges associated with the efficient and precise fabrication of complex nano-structured devices. The development of new techniques that simplify the manufacturing process while enhancing the functionality and quality of the final product is essential for the progression of technologies reliant on advanced lithographic methods.

### Summary of the invention

It is an object of embodiments of the present invention to simultaneously integrate continuous height variation and a plurality of features into a nanoimprint master, with the potential to enhance the uniformity and efficiency of diffraction-based waveguide displays. This is accomplished by a method for producing a master template with variable height features for imprint lithography on a device substrate according to the invention.

The present invention relates to a method for producing a master template with variable height features for imprint lithography on a device substrate, comprising:
- providing a layer stack comprising a substrate, at least one etch stop layer, and at least one pattern layer on the at least one etch stop layer;
- creating height gradation in the at least one pattern layer to obtain a height graded pattern layer;
- forming the master template by providing a pattern comprising a plurality of features into the height graded pattern layer.

In embodiments of the present invention the pattern from the master template may be transferred to the device substrate by imprint lithography.

It is an advantage of embodiments of the present invention that variable height features are created on a device substrate. It is an advantage of embodiments of the present invention that this can be done in an affordable way. It is an advantage of embodiments of the present invention that a master is provided which comprises features of a varying height. This is achieved by first creating height variation on the pattern layer to obtain a height graded pattern layer, and by next providing a pattern into the height graded pattern layer.
In embodiments of the present invention a plurality of features across the height graded pattern layer is provided by the pattern in the height graded pattern layer.

In embodiments of the present invention the pattern may be provided by applying a lithographic process to the height graded pattern layer. This enables precise patterning of the features.

In embodiments of the present invention this is achieved by providing a hard mask on the height graded pattern layer, by patterning and opening the hard mask, and by etching and removing the hard mask.

In embodiments of the present invention the pattern may be provided by fabricating an imprint submaster on a planar substrate and by transferring the pattern from the imprint submaster on the height graded pattern layer, and by etching the transferred pattern in the pattern layer.

It is an advantage of embodiments of the present invention that smaller features can be provided than would be possible when patterning the features on a variable height substrate using a photolithography tool in a height graded hard mask due to depth focus limitations of the photolithography tool.

In embodiments of the present invention the thickness of the pattern layer may be at least as thick as a tallest feature required in the master template. This ensures the pattern layer is sufficiently thick to form the desired features.

In embodiments of the present invention the height gradation may be created through either a series of lithography steps alternating with timed etching steps or through a gray scale photolithography process. These techniques enable controlled formation of the height gradation.

In embodiments of the present invention the height gradation may be created as a gradient along a single in-plane dimension. This provides variation in feature height along one direction.

In embodiments of the present invention the height gradation may be created as a 2D profile along 2 in-plane dimensions. This enables more complex height variation profiles.

In embodiments of the present invention the provided substrate of the layer stack may be a Si substrate. Silicon provides a suitable substrate material.

In embodiments of the present invention the provided etch stop layer of the layer stack may be composed of compounds including, but not limited to, SiN, SiO₂, Al₂O₃, TiN.

In embodiments of the present invention the provided pattern layer of the layer stack may be a SiN or a SiO₂ layer. These dielectric materials can be patterned with high resolution.

In embodiments of the present invention the created height gradation of the pattern layer may be between 25 nm/cm and 300 nm/cm. This range of gradation provides useful variation in feature height for optical applications.

In embodiments of the present invention the provided pattern after transferring the pattern from the master template to the device substrate may be an optical grating, multi-step grating, optical metasurface, or other 2.5D geometries with a period smaller than the wavelength of visible light. These features are useful optical elements for waveguide combiners or other optical devices. The performance of these devices can be enhanced through height variation of these surface relief features.

In embodiments of the present invention the pattern comprising a plurality of features may result in an out-coupler grating and an in-coupler grating in the optical device wherein the efficiency of the out-coupler grating increases with the distance from the in-coupler grating. This configuration provides uniform light intensity from the optical device.

In embodiments of the present invention a master template with variable height features is created using a combination of lithography and etching processes, which allows for precise control over the feature heights. The use of an etch stop layer enables selective etching, ensuring that the height gradation in the pattern layer is accurately maintained during the patterning process. In embodiments of the present invention the pattern layer is deposited to a thickness that matches or exceeds the tallest feature required, thereby facilitating the creation of high aspect ratio structures.

It is an advantage of embodiments of the present invention that height gradation can be introduced through a series of lithography and timed etch loops or a grayscale photolithography process, offering flexibility in the method of creating height variation. It is another advantage that the height gradation can be implemented as a gradient along a single in-plane dimension or as a 2D profile along two in-plane dimensions, which enhances the functionality of the patterned features for various applications.

It is an advantage of a method in accordance with embodiments of the present invention that it is compatible with standard CMOS materials. The substrate used in the layer stack can be a Si substrate, which is commonly used in semiconductor manufacturing, making the process compatible with existing manufacturing technologies. It is also an advantage that the etch stop layer can include materials such as SiN, SiO₂, Al₂O₃, or TiN, which are well-known for their etching resistance and compatibility with various patterning processes.

It is an advantage of embodiments of the present invention that the pattern layer can be composed of materials such as SiN or SiO₂, which are standard in the industry and offer reliable performance. It is a further advantage that the height gradation created in the pattern layer can range from 25 nm/cm to 300 nm/cm, allowing for fine-tuning of the feature heights to meet specific application requirements.

It is an advantage of embodiments of the present invention that the pattern transferred to the device substrate can form optical gratings, multi-step grating, optical metasurface, or other 2.5D geometries with a period smaller than the wavelength of visible light. These are crucial components in various optical devices, including augmented reality systems.

Finally, it is an advantage of embodiments of the present invention that the method can be specifically applied to produce variable height features on a device substrate for an optical device, where the pattern comprising a plurality of features results in an out-coupler grating and an in-coupler grating in the optical device, with the efficiency of the out-coupler grating increasing with the distance from the in-coupler grating. This arrangement can significantly improve the uniformity and efficiency of light output across the device, leading to enhanced visual performance in applications such as augmented reality displays.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 is a schematic representation of the method, for producing a master template with variable height features for imprint lithography on a device substrate, according to embodiments of the present invention.
FIG. 2 is a schematic representation of intermediate stacks obtained when applying a first exemplary method according to embodiments of the present invention.
FIG. 3 is a schematic representation of intermediate stacks obtained when applying a second exemplary method according to embodiments of the present invention.
FIG. 4 shows features with different heights with a stair-shaped top surface obtained using a method in accordance with embodiments of the present invention.
FIG. 5 shows schematic representations of optical devices obtained using a method according to embodiments of the present invention.

In the different figures, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top and over and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", also used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be interpreted as being limited to devices consisting only of components A and B. It means that with respect to the present invention, the only relevant components of the device are A and B. The term "comprising" therefore covers the situation where only the stated features are present and the situation where these features and one or more other features are present. The word "comprising" according to the invention therefore also includes as one embodiment that no further components are present. When the word "comprising" is used to describe an embodiment in this application, it is to be understood that an alternative version of the same embodiment, wherein the term "comprising" is replaced by "consisting of", is also encompassed within the scope of the present invention.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

As used herein, and unless otherwise specified, the term "height gradation" refers to a gradual change in height or thickness across a surface or layer, such that different regions of the surface or layer have different heights or thicknesses. Examples of height gradation include a continuous slope, a series of discrete steps with increasing or decreasing heights, or a pattern of features with varying heights.

In embodiments of the present invention an imprint submaster is created from an original imprint master as an intermediate step to create a final imprint master that is used for device production. In embodiments of the present invention a submaster is an imprint master that was fabricated by taking an original imprint master, imprinting with it, modifying the imprint in some way (such as etch onto variable height material), and then using the new wafer as a final imprint master for device production. For example, a wafer patterned via DUV (Deep Ultraviolet) could be used as the original imprint master. Imprinting from the original master onto a modified substrate and etching the pattern in results in an imprint submaster which may be used as the imprint master for device production.

As used herein, and unless otherwise specified, the term "gray scale photolithography" refers to a lithographic process that uses a photomask with varying degrees of transparency to create height gradation to the pattern layer to obtain a height graded pattern layer. The varying transparency of the photomask allows different amounts of light to pass through, resulting in different exposure levels and, consequently, a height graded pattern layer after development of the photoresist. Examples of gray scale photolithography include using a photomask with grayscale patterns, such as a continuous tone mask or a half-toned mask.

As used herein, and unless otherwise specified, the term "optical grating" refers to a periodic structure that diffracts light into different directions based on the wavelength and angle of the incident light. Optical gratings typically consist of a series of parallel lines or grooves with a specific spacing and depth. Examples of optical gratings include diffraction gratings, Bragg gratings, and surface relief gratings, which can be used in various applications such as spectrometers, wavelength division multiplexing, and beam splitting.

As used herein, and unless otherwise specified, the term "out-coupler grating" refers to a grating structure used in an optical device to couple light out of a waveguide or a substrate. The efficiency of an out-coupler grating refers to the percentage of light that is successfully coupled out of the waveguide or substrate. Examples of out-coupler gratings include surface relief gratings, volume gratings, and embedded gratings, which can be designed with varying periods, depths, or slant angles to optimize the coupling efficiency.

As used herein, and unless otherwise specified, the term "in-coupler grating" refers to a grating structure used in an optical device to couple light into a waveguide or a substrate. The in-coupler grating is typically designed to match the wavelength and angle of the incident light for efficient coupling. Examples of in-coupler gratings include surface relief gratings, volume gratings, and embedded gratings, which can be optimized for specific wavelengths and angles of incidence.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

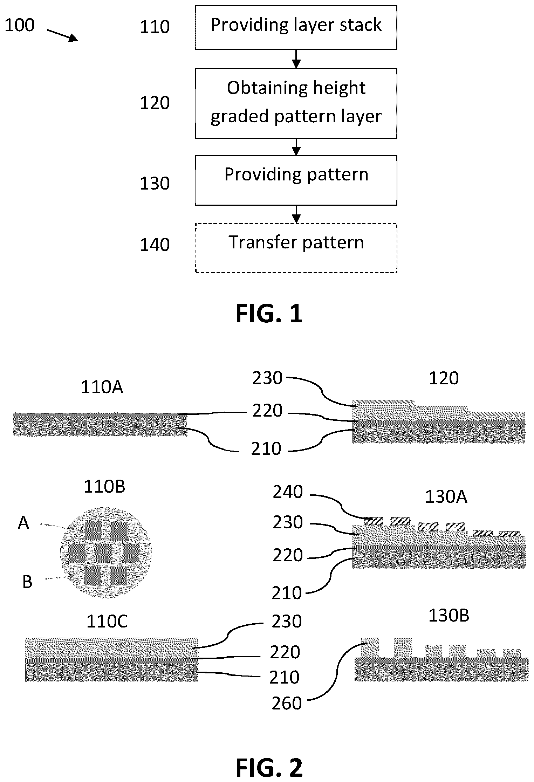

The present invention relates to a method (100) for producing a master template with variable height features for imprint lithography on a device substrate, as illustrated in FIG. 1. The method (100) comprises providing (110) a layer stack comprising a substrate, an etch stop layer on the substrate, and a pattern layer on the etch stop layer. In embodiments of the present invention the provided substrate of the layer stack may be a Si substrate. In embodiments of the present invention the provided etch stop layer of the layer stack may comprise compounds including SiN, SiO₂, Al₂O₃, TiN. In embodiments of the present invention the provided pattern layer of the layer stack may be a SiN or SiO₂ layer. In embodiments of the present invention the thickness of the pattern layer may be at least as thick as a tallest feature required in the master template. This ensures the pattern layer is sufficiently thick to form the desired features.

Height gradation is created (120) in the pattern layer to obtain a height graded pattern layer. In embodiments of the present invention the height gradation may be created through either a series of lithography steps alternating with timed etching steps or through a gray scale photolithography process. These techniques enable controlled formation of the height gradation. In embodiments of the present invention the height gradation may be created as a gradient along a single in-plane dimension. This provides variation in feature height along one direction. In embodiments of the present invention the height gradation may be created as a 2D profile along 2 in-plane dimensions. This enables more complex height variation profiles. In embodiments of the present invention the created height gradation of the pattern layer may be between 25 nm/cm and 300 nm/cm. This range of gradation provides useful variation in feature height for optical applications.

The master template is formed by providing (130) a pattern comprising a plurality of features into the height graded pattern layer. Imprint lithography is then utilized to transfer (140) the pattern from the master template to the device substrate. In embodiments of the present invention the provided pattern after transferring (140) the pattern from the master template to the device substrate may be an optical grating. Variable height gratings are useful optical elements. In embodiments of the present invention the provided pattern may comprise features with a flat top surface or it may comprise features with a stair-shaped top surface comprising at least two areas with different height. The flat or stair-shaped, stepped, top surface provides optical functionality.

FIG. 2 shows intermediate stacks obtained when applying a first exemplary method according to embodiments of the present invention. In steps (110A), (110B) and (110C) a layer stack is provided. In step (110A) an etch stop layer (220) is deposited on a silicon substrate (210). In step (110B), pattern areas A are distinguished from protected areas B which should not be patterned with variable height. These areas B are, in embodiments of the present invention, masked by photolithography. In step (110C), a pattern layer (230) is deposited over the etch stop layer. In the next steps only the pattern areas A are shown. In step (120), height gradation is created in the pattern layer (230) to obtain a height graded pattern layer. This may be achieved by performing lithography and timed etch loops to create height gradation in the pattern layer. Multiple lithography steps are alternated with timed etching to create stepped plateaus of increasing height in the pattern layer. Alternatively a gray scale photolithography process may be applied to create the heigh gradation. The first option for creating the height gradation is preferable because it offers better repeatability and lower manufacturing cost than grayscale lithography. In this exemplary method, the pattern is provided (130) by applying a lithographic process to the height graded pattern layer. In step (130A), a hard mask (240) is patterned and opened over the height graded pattern layer to define the features to be etched. The lithographic process may comprise applying a hard mask conformally to the height graded pattern layer, printing and opening the pattern in the hard mask, etching the pattern into the height graded pattern layer, and stripping the hard mask. In step (130B), the hard mask pattern is etched into the height graded pattern layer (230), stopping on the etch stop layer (220). This transfers the pattern into the pattern layer. The hard mask is then removed, leaving the variable height patterned features (260) on the etch stop layer and substrate.

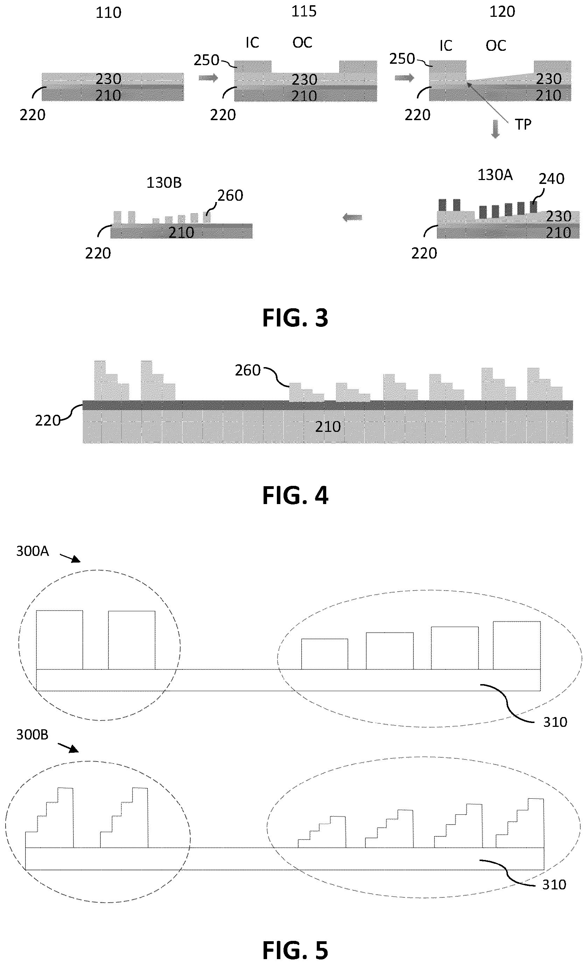

FIG. 3 shows intermediate stacks obtained when applying a second exemplary method according to embodiments of the present invention. In this method, an imprint master is first fabricated on a separate planar substrate using standard imprint lithography techniques to create a fixed height pattern. The imprint master is then used to imprint the pattern (240) onto the height graded pattern layer (230) formed by the process in FIG. 3 steps (110, 115, 120). In this exemplary method first a layer stack comprising a substrate (210), an etch stop layer (220), and a pattern layer (230) is provided (110). The pattern layer (230) may for example comprise a nitride or an oxide. In a next step (115), a protective layer (250) is provided (115) for protecting an in-coupler region IC and the protective layer is open at an out-coupler OC region. In a next step height gradation is created (120) to the pattern layer (230). The protective layer (250) may for example be a photoresist or hard mask. It may be required to taper TP in a gap between IC and OC to avoid a large step and keep imprint conformal. The pattern is provided into the height graded pattern layer (230) by fabricating an imprint submaster comprising a negative replica of the required pattern on a planar substrate and transferring the pattern from the imprint submaster onto the height graded pattern layer (230), thereby patterning (130A) a hard mask (240) over the height graded pattern layer. After imprinting, the transferred pattern is etched (130B) into the height graded pattern layer, stopping on the etch stop layer, thereby forming the master template with the variable height patterned features (260). This second exemplary method of the present invention avoids depth of focus limitations by decoupling the variable height formation from the patterning of the small features. The result is the variable height patterned features on the etch stop layer and substrate, as in the first method.

In embodiments of the present invention the variable height features of the master template may have a flat top surface, as illustrated by the features 260 in FIG. 2 and FIG. 3, or a stair-shaped top surface comprising at least two areas with different height, as illustrated by the features 260 in FIG. 4.

This method (100) allows for efficient production of a master template with variable height features for imprint lithography on a device substrate.

In embodiments of the present invention the method (100) is a method for producing a master template with variable height features for imprint lithography on a device substrate for an optical device (300). Applying the method (100) to make an optical device enables improved optical performance. In embodiments of the present invention the pattern comprising a plurality of features may result in an out-coupler grating and an in-coupler grating in the optical device wherein the efficiency of the out-coupler grating increases with the distance from the in-coupler grating. This configuration provides uniform light intensity from the optical device.

FIG. 5 shows a schematic representation of exemplary optical devices (300A, 300B) obtained using a method (100) according to embodiments of the present invention. There are only some examples of optical devices and the invention is not limited thereto. The optical device comprises a transparent substrate (310). The left features of these optical devices may form an in-coupler grating and the right features may form an out-coupler grating. The features of the optical device (300A) have a flat top surface and those of optical device (300B) have a stair-shaped top surface. The features on the right have a height that increases with increasing distance from the features on the left. The features on the left are pillars of equal size (equal height) and with a flat top surface (300A) or a stair-shaped top surface (300B). Preferably their hight is slightly higher than the highest feature on the right.

In embodiments of the present invention the features on the left may be an input coupler and those on the right an output grating. The height of the output grating features may gradually increase with distance from the input coupler. This allows the efficiency of the output grating to increase to compensate for the decreasing amount of guided light reaching the output grating further from the input, through the substrate 310. The variable height is achieved using the methods (100) described in FIG. 2 or FIG. 3.

An optical device (300) can be made using an master template obtained using a method in accordance with embodiments of the present invention (see for example FIG. 2, FIG. 3, or FIG. 4 for the master templates). In embodiments of the present invention the cross section of the optical device and the cross section of the master template for the optical device are the same. There are, however, differences with respect to the materials used. The cross section of the actual device and of the master template used for device fabrication is the same because the master template is first replicated onto a flexible stamp ('negative' of the master) and then the flexible stamp is used to make the device ('negative' of the stamp and thus same profile as the master). This is a known approach for full wafer NIL processes. The flexible stamp can for example be obtained by casting and curing a liquid precursor of a soft stamp material onto a silicon master. This stamp is then used for the printing step on the device substrate. There is, however, a difference in substrate and materials stack. The master template can for example have a layer of SiO2 or a stack of SiO2 and other materials on a Si substrate, whereas the optical device (FIG. 5) has a transparent substrate 310 (for example some specialty glass or other high-refractive index transparent material) with a layer (stack) of high-index material for the patterns.

Having grating features with a top surface comprising at least two areas with different height provides an additional degree of control over the light propagation in the optical device. The multiple levels of the individual grating features allow finer control over the angular distribution of the outcoupled light in addition to the efficiency control provided by the height variation between different grating features. The variable height multi-level grating is achieved using a method in accordance with embodiments of the present invention.

An optical device obtained using embodiments of the present invention may comprise an in-coupler grating and an out-coupler grating. The out-coupler grating may have variable height features each comprising a staircase structure. The height of the staircase structure increases with distance from the in-coupler grating. This results in the efficiency of the out-coupler grating increasing with distance from the in-coupler grating while also directing light towards the user. Such a grating with variable height features comprising features with a staircase structure is made using a master template obtained using a method in accordance with embodiments of the present invention.

It is an advantage of embodiments of the present invention that a method is developed to improve the uniformity of diffraction-based waveguide displays by combining continuous height variation and multi-step features in a nanoimprint master. It is an advantage of embodiments of the present invention that it enables affordable replication of out-coupler gratings on device substrates for improved display quality. It is an advantage of embodiments of the present invention that using standard DUV (Deep UltraViolet) and CMOS processing better repeatability and lower manufacturing cost can be obtained compared to grayscale e-beam processes.

For a typical device with out-coupler dimensions of about 25-35 mm along the direction of light propagation, a 1D height variation from 20-40 nm closest to the in-coupler to 100-200 nm furthest away required 5-7 photomasks to generate step changes of <2 nm, with minimum widths of 195 µm to 1.09 mm. For a gray-scale photolithography process, 1nm edges can be achieved with mask pixels >10 µm. 2D profiles can also be patterned using photomasks.

In embodiments of the present invention the process flow to pattern variable height features involves depositing an etch stop layer and a pattern layer on a substrate, creating height gradation in the pattern layer, and then printing, opening, and etching the pattern into the height graded pattern layer (FIG. 2 and FIG. 3).

Binary gratings represent the simplest case of a periodic staircase structure. In another implementation, the gratings may be composed of a more complex staircase structure, with steps varying in CD and height while retaining a fixed pitch. These features allow additional control over light in an optical device, directing it toward the user and away from the world.

In an exemplary embodiment of the present invention a submaster is created by an imprint and etch process, where the imprint master is fabricated on a standard planar substrate and height gradation is applied to a second wafer. The master may be used to fabricate a NIL (Nano Imprint Lithography) stamp, which is then imprinted on top of a height graded wafer. Dry etch may be used to finish fabrication of the height graded submaster, which is then used for actual device fabrication.

It is an advantage of a method in accordance with embodiments of the present invention that it enables the combination of variable height features and multi-step structures in a single layer, creating features that can be replicated via a single nanoimprint lithography step to provide an affordable path to manufacturing. This combination of features in the display architecture provides multiple device level improvements, including improved power efficiency, color uniformity, and user privacy.

In an exemplary embodiment of the present invention a master template with a 1D height gradient and binary grating is fabricated. A Si substrate is provided and a for example 50 nm thick SiN etch stop layer is deposited on the substrate. A for example 250 nm thick SiO₂ pattern layer is then deposited on the etch stop layer. A series of 6 lithography and timed etch loops may be performed to create a height gradation in the SiO₂ pattern layer, resulting in a gradient from for example 40 nm to 220 nm over a distance of for example 30 mm. Binary gratings with a pitch of for example 500 nm and a duty cycle of for example 50% are then patterned into the height graded SiO₂ layer using standard photolithography and etching processes. The resulting master template is used in a nanoimprint lithography process to transfer the variable height binary grating pattern to multiple device substrates.

In yet another exemplary embodiment of the present invention a master template with a 2D height gradient and multi-step staircase gratings is fabricated. A Si substrate is provided and a for example 20 nm thick Al₂O₃ etch stop layer is deposited. A for example 180 nm thick SiN pattern layer is then deposited. A grayscale photolithography process is used to create a 2D height gradient in the SiN layer, with the height varying from for example 30 nm to 150 nm over an area of for example 25 mm x 25 mm. A thin SiO₂ hard mask is conformally applied over the height graded SiN layer. A multi-step staircase grating pattern with a pitch of for example 400 nm and step heights of for example 30 nm, 60 nm, and 90 nm is printed and etched into the hard mask and height graded SiN layer. The etched pattern is filled with amorphous Si, which is then planarized back to the hard mask using CMP or dry etch. The hard mask is stripped, resulting in a master template with variable height multi-step staircase gratings. This master template is used for nanoimprint lithography on device substrates.

In yet another exemplary embodiment of the present invention a variable height master template is fabricated using an imprint submaster. First, an imprint submaster with a binary structure (no variable height) is fabricated on a planar Si substrate with a SiO₂ pattern layer. The pattern consists for example of a complex 3-step staircase grating pattern with a pitch of for example 350 nm and step heights of for example 40 nm, 70 nm, and 100 nm. Separately, a Si substrate is provided and a height gradation from for example 20 nm to 120 nm is created in a SiO₂ layer using a grayscale photolithography process. The single-height imprint submaster is used to fabricate a NIL stamp, which is then used to imprint the staircase grating pattern onto the height graded SiO₂ layer. The imprinted pattern is etched into the height graded layer using dry etching, resulting in a variable height master template with 3-step staircase gratings. This master template is then used for nanoimprint lithography on device substrates for fabricating optical devices with improved efficiency and uniformity.

In yet another exemplary embodiment of the present invention a variable height master template with independently controlled height gradation on multiple levels may be fabricated. A Si substrate is provided and a stack of alternating SiO₂ and SiN layers is deposited, with each layer having a thickness of for example 80 nm. Height gradation is introduced to the top SiO₂ layer using a series of lithography and timed etch loops, creating a gradient from for example 30 nm to 110 nm over a distance of 30 mm. A second height gradation is created in the middle SiN layer using a grayscale photolithography process, with the height varying from for example 50 nm to 90 nm over the same distance. A grating pattern may then be printed and etched into the height graded stack using standard photolithography and etching processes. The resulting master template has variable height grating with independently controlled height gradation on the top and middle levels. This master template may be used for nanoimprint lithography on device substrates to fabricate optical devices with enhanced control over light extraction and direction.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method (100) for producing a master template with variable height features for imprint lithography on a device substrate, comprising:
- providing (110) a layer stack comprising a substrate, at least one etch stop layer, and at least one pattern layer on the at least one etch stop layer;
- creating (120) height gradation in the at least one pattern layer to obtain a height graded pattern layer;
- forming the master template by providing (130) a pattern comprising a plurality of features into the height graded pattern layer.

2. The method (100) according to claim 1, wherein the pattern is provided (130) by applying a lithographic process to the height graded pattern layer.

3. The method (100) according to claim 1, wherein the pattern is provided (130) by fabricating an imprint submaster on a planar substrate and by transferring the pattern from the imprint submaster on the height graded pattern layer, and by etching the transferred pattern in the pattern layer.

4. The method (100) according to any of the previous claims wherein the thickness of the pattern layer is at least as thick as a tallest feature required in the master template.

5. The method (100) according to any of the previous claims wherein the height gradation is created (120) through either a series of lithography steps alternating with timed etching steps or through a gray scale photolithography process.

6. The method (100) according to any of the previous claims wherein the height gradation is created (120) as a gradient along a single in-plane dimension.

7. The method (100) according to any of the claims 1 to 6 wherein the height gradation is created (120) as a 2D profile along 2 in-plane dimensions.

8. The method (100) according to any of the previous claims wherein the provided (110) substrate of the layer stack is a Si substrate.

9. The method (100) according to any of the previous claims wherein the provided (110) etch stop layer of the layer stack comprises SiN, and/or Si02, and/or Al2O3, and/or TiN.

10. The method (100) according to any of the previous claims wherein the provided (110) pattern layer of the layer stack is a SiN, or a Si02 layer.

11. The method (100) according to any of the previous claims wherein the created (120) height gradation of the pattern layer is between 25 nm/cm and 150 nm/cm.

12. The method (100) according to any of the previous claims wherein the provided (130) pattern after transferring (140) the pattern from the master template to the device substrate is an optical grating.

13. The method (100) according to any of the previous claims wherein the provided (130) pattern comprises features with a sloped top surface or a top surface comprising at least two areas with different height.

14. The method (100) according to any of the previous claims wherein the method (100) is a method for producing variable height features on the device substrate for an optical device.

15. The method (100) according to claim 14, wherein the pattern comprising a plurality of features results in an out-coupler grating and an in-coupler grating in the optical device wherein the efficiency of the out-coupler grating increases with the distance from the in-coupler grating.
